# EUROPÄISCHE PATENTANMELDUNG

(11) **EP 2 343 805 A2**
(43) Veröffentlichungstag der Anmeldung: **13.07.2011**
(21) Anmeldenummer: 10190106.4
(22) Anmeldetag: 05.11.2010
(51) Int. Cl.: H03K 17/96

(54) **Sensierendes Flächenelement und Anordnung aus sensierenden Flächenelementen**

(30) Priorität: 05.01.2010 DE 102010000669
(71) Anmelder: Robert Bosch GmbH, 70442 Stuttgart (DE)
(72) Erfinder: Schaaf, Ulrich, 73667 Kaisersbach (DE); Herrmann, Falk, 310052 Hangzhou/ Bing Jiang District (CN); Wahl, Ruben, 71394 Kernen (DE); Kugler, Andreas, 73553 Alfdorf (DE); Zimmermann, Andre, 73730 Esslingen (DE); Thuersam, Markus, 2300 La Chaux-De-Fonds (CH); Denes, Istvan, 71336 Waiblinge/Hohenacker (DE); Stihler, Patrick, 73760 Ostfildern (DE)

(57) **Zusammenfassung**

Die Erfindung betrifft ein sensierendes Flächenelement,
das eine Sensoranordnung (8) aus mehreren Sensoreinheiten (9) aufweist, wobei die Sensoreinheiten (9) jeweils mindestens einen taktilen Schalter aufweisen und bei Aktivierung ihres Schalters Signale ausgeben.

Erfindungsgemäß ist vorgesehen, dass
die Sensoreinheiten (9) jeweils mindestens einen Schwingkreis aufweisen,
die Schwingkreise parallel an gemeinsame Leiterbahnsysteme (10, 11) angeschlossen sind, und
die Signale der Sensoreinheiten (9) Stromsignale der Schwingkreise sind,
wobei die Stromsignale der Schwingkreise zumindest einiger Sensoreinheiten (9) des Flächenelementes (1) unterschiedlich sind.

## Beschreibung

### Stand der Technik

Sensierende Flächenelemente werden insbesondere als Fußbodenbeläge in Räumen ausgelegt, um die Anwesenheit von Personen zu detektieren und ggf. weitergehende Aussagen zu treffen. Hierbei kann in dem Flächenelement eine Vielzahl von Sensoren angeordnet sein, die taktil bzw. berührungsempfindlich sind und bei Belastung des Fußbodens ein Signal ausgeben, das nachfolgend ausgewertet wird.

Die Sensoren können insbesondere kapazitive Sensoren sein, deren Kapazitäten sich bei Belastung des Fußbodenbelages ändert. Die DE 10 2006 027 213 A1 beschreibt eine Textilschicht-Anordnung, bei der ein Silizium-Chip als elektronisches Bauelement zwischen zwei Textilschichten eingebracht wird und bei Belastung ein kapazitives Signal ausgibt. Die elektrischen Zuleitungen zu den Sensoren können durch leitfähige Schichten in dem Textilmaterial ausgebildet sein.

Die WO 2006/083997 A2 beschreibt eine wasserbeständige Schaltermatte, die flexible, aktivierbare Schalter aufweist. Hierbei ist ein Schalter als am Unfang entlang laufendes Band ausgebildet und zwischen zwei Schichten gelegt, wobei innerhalb dieses Schalters innere Bandschalter angeordnet sein können, die jeweils ein Paar von vertikal beabstandeten, in einer isolierenden Umhüllung aufgenommen elektrischen Leitern aufweisen und bei Druckbelastung geschlossen werden können. Die räumliche Auflösung einer derartigen Schaltermatte ist somit sehr gering.

Die US 6,515,586 B1 zeigt ein taktiles Sensorsystem mit einem Bodenbelag, in dem eine taktile bzw. berührungsempfindliche Sensorschicht integriert ist. Diese Sensorschicht weist eine Vielzahl von Sensoren und eine Steuereinrichtung auf, die eine Person oder ein Objekt durch die Aktivierung der unterschiedlichen Sensoren erkennen kann. Das flexible Material kann hierbei auf einer Rolle aufgenommen werden, so dass es in Länge und Breite geeignet angepasst und in Räumen verlegt werden kann. Die Sensoren können Drucksensoren, Kraftsensoren, kraft- und positionssensierende Widerstände oder näheempfindliche Sensoren sein. Die Sensorsignale werden über Verbindungsknoten aufgenommen und zu der Steuereinrichtung weitergegeben.

Nachteilhaft an derartigen sensierenden Flächenelementen ist im Allgemeinen, dass eine qualitativ gute Sensierung von Personen und anderen Objekten eine hohe Sensor-Flächendichte erfordert, die wiederum auch zu einem hohen Leitungsaufwand für die Zu- und Abführung der Stromversorgung und der Sensorsignale und somit zu hohen Kosten führt. Weiterhin ist die Ausbildung der Sensoren komplex und somit kostspielig.

### Offenbarung der Erfindung

Erfindungsgemäß wird ein sensierendes Flächenelement geschaffen, das eine Sensoranordnung mit einer Vielzahl von Sensoreinheiten aufweist. Die Sensoreinheiten sind somit lateral (in der Fläche ) zueinander beabstandet; sie können insbesondere in einer Matrixanordnung, d.h. mit Spalten und Zeilen, angeordnet sein. Die Sensoreinheiten weisen jeweils mindestens einen taktilen Schalter auf.

Erfindungsgemäß wird unter einem taktilen Schalter eine Schalteinrichtung verstanden, die in Abhängigkeit einer Berührung, Krafteinwirkung, Druckeinwirkung oder auch der Nähe eines Objektes (proximity switch), insbesondere eines menschlichen Körpers, ihre Schaltstellung verändert. Ein taktiler Schalter kann insbesondere ein Druckschalter sein, der bei Druckbelastung einen Kontakt zwischen seinen Sensorflächen ausbildet.

Den Sensoreinheiten ist jeweils mindestens ein eigener Schwingkreis (Oszillator) zugeordnet. Hierbei kann der Schwingkreis vollständig Teil der Sensoreinheit sein, es ist jedoch auch eine Ausbildung möglich, bei der Teile des Schwingkreises durch Komponenten gebildet werden, die einigen Sensoreinheiten gemeinsam zugeordnet sind. So kann z. B. in einer Reihenschaltung von Schwingkreisen eine Spule oder ein Kondensator gemeinsam genutzt werden. Weiterhin können den Sensoreinheiten oder einigen Sensoreinheiten auch zwei oder mehr Schwingkreise zugeordnet sein.

Erfindungsgemäß werden einige Vorteile erreicht. Da die Schwingkreise parallel geschaltet sind und spezifische bzw. unterschiedliche Stromsignale ausgeben, kann somit aus einem gemeinsam aufgenommenen Gesamt-Stromsignal eine Auswertung auf die einzelnen Schwingkreise erfolgen und z. B. festgestellt werden, welche Sensoreinheiten zu welchem Zeitpunkt jeweils aktiviert sind.

Somit wird der Leitungsaufwand bzw. Verkabelungsaufwand auch einer hohen Anzahl von Sensoren deutlich vereinfacht. Insbesondere können die Sensoren über nur zwei gemeinsame Leiterbahnsysteme angeschlossen und hierbei parallel geschaltet sein. Bei Belastung des Flächenelementes im Bereich einer Sensoreinheit schaltet dessen taktiler Schalter somit und kontaktiert hierdurch den mindestens einen Schwingkreis der Sensoreinheit zwischen die beiden Leiterbahnsysteme, so dass diese Sensoreinheit mindestens ein Stromsignal auf die Leiterbahnsysteme ausgibt. Somit wird durch Überlagerung sämtlicher aktivierter Sensoreinheiten des Flächenelementes ein Gesamt-Stromsignal gewonnen, das nachfolgend ausgewertet werden kann, z. B. durch eine Frequenzanalyse.

Erfindungsgemäß können sämtliche Stromsignale aufgrund einer ihrer Charakteristiken unterschiedlich sein; es ist jedoch auch möglich, dass z. B. einige benachbarte Sensoreinheiten gleiche Stromsignale ausgeben und somit gemeinsam erfasst werden. Vorteilhafterweise unterscheiden sich jedoch die Stromsignale sämtlicher Sensoreinheiten in mindestens einer Charakteristik. Relevante Charakteristiken können insbesondere sein: Resonanzfrequenz, Dämpfung, Frequenzgang, d.h. auch Phasenverschiebung, sowie Stromstärke. Unterschiedliche Resonanzfrequenzen können durch unterschiedliche Kapazität und/oder unterschiedliche Induktivität erreicht werden, unterschiedliche Dämpfungen durch unterschiedliche Widerstände.

Die Ausbildung der Leitungssysteme und auch der gesamten Sensoreinheiten kann sehr kostengünstig durch strukturiertes Aufbringen jeweils einer leitfähigen Schicht auf der Oberseite und Unterseite einer mittleren nicht leitfähigen Schicht erfolgen. Somit ist eine kostengünstige und dennoch solide Ausbildung der Sensoreinheiten bei geringer Störanfälligkeit möglich. Die leitfähigen Schichten können z. B. durch Prägen, Drucken oder Jetten strukturiert ausgebildet werden. Erfindungsgemäß kann insbesondere ein Endlosverfahren eingesetzt werden, wodurch geringe Herstellungskosten bei hoher Reproduktionsgenauigkeit erreichbar sind.

Vorteilhaft ist auch, wenn bei einer Matrixanordnung die Spalten und Zeilen sich jeweils durch eine Charakteristik unterscheiden. Wenn z. B. zeilenweise eine gleiche Resonanzfrequenz vorgesehen ist, können die Sensoreinheiten als Reihenschaltung eines Schalters, Kondensators und Widerstandes ausgebildet sein, und bei Kontaktierung ihres Schalters an eine gemeinsam in jeder Zeile vorgesehene Spule geschaltet werden, wobei die Spulen der einzelnen Zeilen sich entsprechend unterscheiden, um die unterschiedliche Resonanzfrequenzen auszubilden. Somit kann die Integration und Flächendichte der Sensoreinheiten weiter erhöht werden und die Herstellungskosten weiter gesenkt werden.

Weiterhin kann eine Sensoreinheit auch zwei oder mehr Schwingkreise aufweisen und somit bei seiner Aktivierung zwei Stromsignale ausgeben,

Vorteilhafterweise dient die Spannungsversorgung der Sensoreinheiten bereits auch der Abnahme der Stromsignale über die Leitungssysteme, so dass der LEitungsaufwand gering ist. Somit kann ein breitbandiges Rausch-Spannungssignal eingegeben und der Strom gemessen werden.

Das obere und untere Leiterbahnsystem kann jeweils kammartig mit einer Hauptleiterbahn und hiervon z. B. orthogonal abgehenden, parallelen Nebenleiterbahnen ausgebildet werden. Indem die Leiterbahnsysteme auf der Ober- und Unterseite zueinander orthogonal versetzt sind, wird mit relativ geringem Leitungsaufwand eine Matrixstruktur zur Kontaktierung sämtlicher Sensoreinheiten geschaffen.

Erfindungsgemäß wird insbesondere auch erkannt, dass die Sensoreinheiten sich mit überraschend geringem Aufwand in den zwei leitfähigen Schichten und gegebenenfalls der mittleren nicht leitfähigen Schicht realisieren lassen. Ein voll funktionsfähiger Schwingkreis kann bereits durch eine Reihenschaltung aus Kondensator, Spule und Widerstand sowie den zusätzlichen Schalter zur Aktivierung des Schwingkreises durch Anschluss an die Leiterbahnsysteme ausgebildet werden. Der Druckschalter lässt sich einfach als Paar von Schalterflächen in der oberen leitfähigen Schicht und unteren leitfähigen Schicht mit einem Freiraum dazwischen ausbilden.. Der Kondensator lässt sich durch überlappende oder aneinander liegende Elemente oder Flächenelemente ausbilden. Die Spule lässt sich als Flachspule bzw. Spiralspule ausbilden, d. h. im Wesentlichen in einer leitfähigen Schicht, ggf. mit einer Durchkontaktierung von ihrem mittleren Punkt zu der anderen leitfähigen Schicht. Durchkontaktierungen zwischen der oberen und unteren leitfähigen Schicht können erfindungsgemäß geschaffen werden durch Ausbildung einer Ausnehmung bzw. Loch in der mittleren nicht leitfähigen Schicht und Auftragen der leitfähigen Schichten in diese Ausnehmung.

Weiterhin wird erfindungsgemäß auch eine Anordnung aus mehreren derartigen Flächenelementen geschaffen, wobei jedes Flächenelement mit seinen beiden Hauptleiterbahnen angeschlossen wird, z. B. an eine dezentrale Steuereinrichtung, die den Rauschgenerator zur Ausgabe eines breitbandigen Spannungs- Rauschsignals bereit stellt, so dass jeder Schwingkreis entsprechend bei seiner Resonanzfrequenz angeregt wird, und das Gesamt-Stromsignal aufnimmt, vorzugsweise auch verarbeitet unter Rauschfilterung usw. Die dezentralen Steuereinrichtungen können nachfolgend über Bus-Systeme an eine Zentraleinheit angeschlossen werden. Somit ergibt sich der Vorteil, dass ein modulares, einfach erweiterbares System geschaffen wird, mit einer Zentraleinheit, die weitergehende Auswertungen vornehmen kann, z.B. zeitliche und räumliche Auswertungen zur Erkennung von Bewegungsmustern, wobei z. B. Alarmsignale ausgegeben werden können bei Erkennen eines Eindringlings oder eines Sturzfalls oder anderen Unglücksfalls.

### Kurze Beschreibung der Zeichnungen

Es zeigen :
- Fig. 1: eine leicht perspektivische Aufsicht auf ein erfindungsgemäßes Flächenelement gemäß einer Ausführungsform;
- Fig. 2: eine Detailvergrößerung aus Fig. 1 mit einer Sensoreinheit;
- Fig. 3: ein schematisches Schaltdiagramm der Sensoreinheiten;
- Fig. 4: einen Schnitt durch das Flächenelement im Bereich eines Druckschalters;
- Fig. 5: eine schematische Darstellung der Messung und Auswertung eines Stromsignals einer Sensoreinheit;
- Fig. 6: ein Strom-Frequenz-Diagramm der Stromsignale der Sensoreinheiten eines Sensornetzwerkes gemäß einer Ausführungsform;
- Fig. 7: zeigt ein zu Fig. 2 alternatives Schaltdiagramm mit gemeinsamer Nutzung einer Spule pro Reihe bzw. Zeile;
- Fig. 8: eine weitere Ausführungsform einer Sensoreinheit mit zwei parallel geschalteten Schwingkreisen mit unterschiedlichen Charakteristiken;
- Fig. 9: eine Anordnung aus mehreren Flächenelementen gemäß einer Ausführungsform;
- Fig. 10: ein Flussdiagramm eines erfindungsgemäßen Verfahrens;
- Fig. 11: ein Strom-Frequenz-Diagramm eines Strom-Mess-Signals;

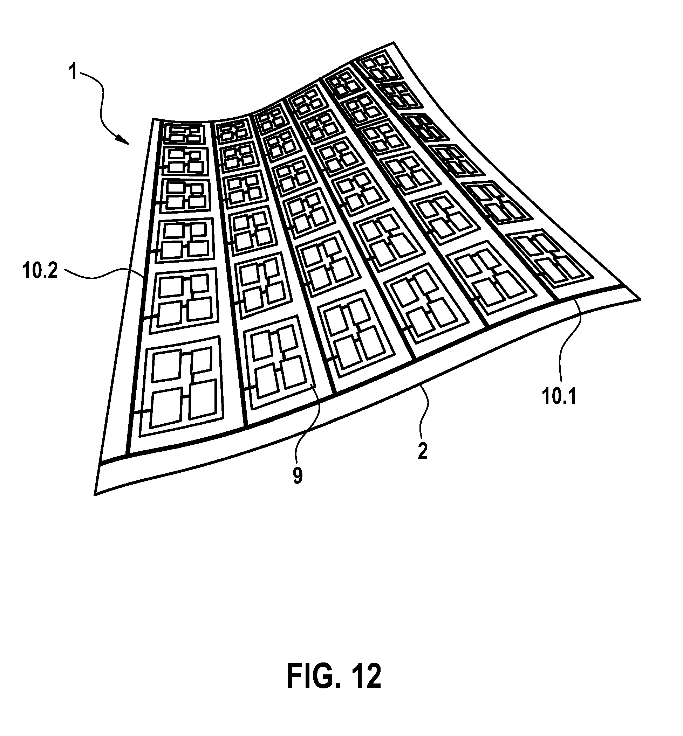

- Fig. 12: eine perspektivische Ansicht von oben auf ein erfindungsgemäßes flexibles Flächenelement,

### Beschreibung der Ausführungsformen

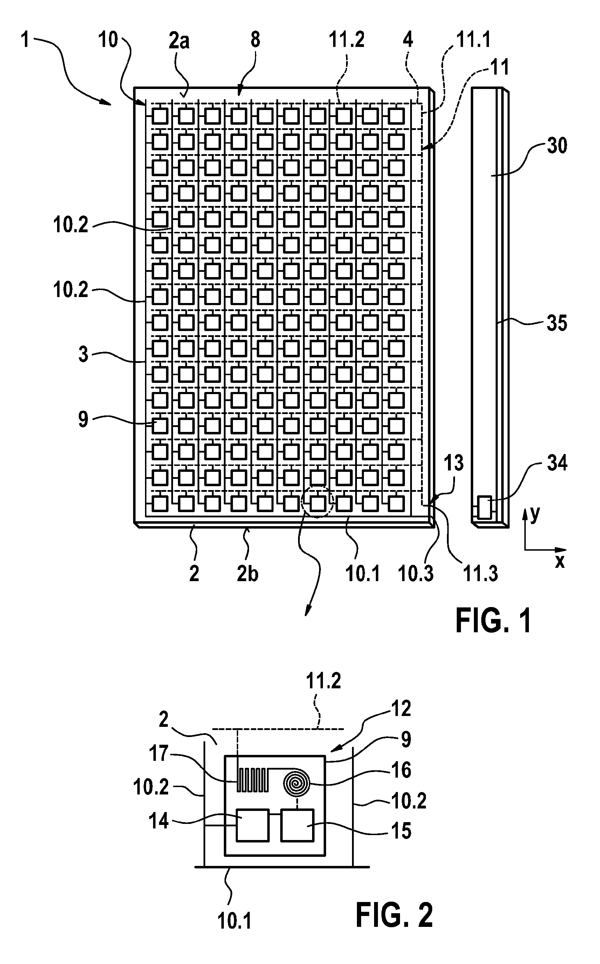

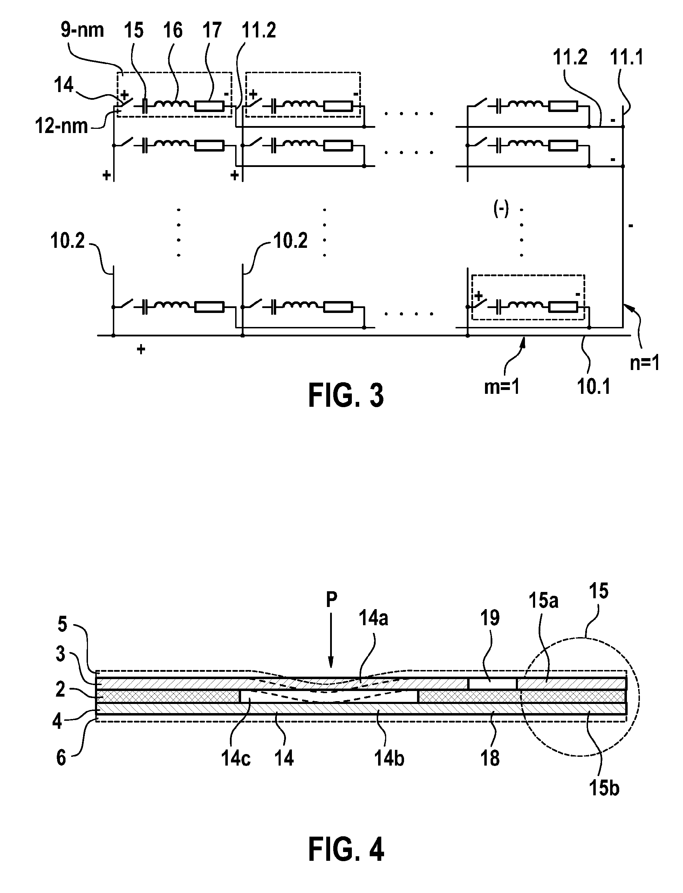

Ein erfindungsgemäßes sensierendes Flächenelement 1 weist gemäß der- leicht perspektivischen - Draufsicht der Fig. 1 sowie dem Vertikalschnitt der Fig. 4 eine mittlere, flexible Schicht 2 aus elektrisch nicht leitfähigen, flexiblem Material auf. Die Schicht 2 kann dünn, d.h. als Folie von z. B. weniger als 1 mm oder einige mm, oder auch dicker zur Erhöhung ihrer Widerstandsfähigkeit und als Dielektrikum ausgebildet sein. Sie kann z.B. aus einem Kunststoff, insbesondere einem isolierenden, nachgiebigen Kunststoff, z. B. als Kunststofffolie oder aus einem geschäumten oder perforierten Kunststoff, oder auch z. B. aus einem Textilmaterial (gewebt oder ungewebt) hergestellt sein. Weiterhin kann die nicht leitfähige Schicht 2 auch durch eine Schichtfolge von isolierenden Einzelschichten gebildet sein. Auf der Oberseite 2a der nicht leitfähigen Schicht 2 ist eine obere leitfähige Schicht 3 strukturiert aufgetragen, entsprechend ist auf ihrer Unterseite 2b eine untere leitfähige Schicht 4 strukturiert aufgetragen. Ergänzend kann z.B. wie in Fig. 4 gestrichelt angedeutet auf der oberen leitfähigen Schicht 3 eine obere Isolationsschicht 5 und unterhalb der unteren leitfähigen Schicht 4 eine untere Isolationsschicht 6 aufgetragen sein, die dem Schutz der mittleren drei Schichten 2, 3, 4 gegen Abrieb von oben und Beeinflussung von unten, z.B. auch gegen unzulässige Kontaktierung der leitfähigen Schichten 3, 4 dienen. Das sensierende Flächenelement 1 ist als ganzes flexibel und kann z.B. aufgerollt und in Rollen transportiert werden, um es vor Ort wie einen Teppich zu verlegen. Es kann auch unter einen Teppich verlegt werden, wobei dann z.B. die obere lsolationsschicht 5 entfällt.

In der oberen leitfähigen Schicht 3 ist ein erstes, oberes Leiterbahnsystem 10 strukturiert; entsprechend ist in der unteren leitfähigen Schicht 4 ein zweites, unteres Leiterbahnsystem 11 strukturiert, das in der Draufsicht der Fig. 1 nur gestrichelt angedeutet ist. Das erste Leiterbahnsystem 10 ist vorteilhafterweise kammartig bzw. mit einer Kammstruktur ausgebildet, mit einer ersten Hauptleiterbahn 10.1, die in einer ersten Richtung des Flächenelementes 1 - gemäß Fig. 1 in der x-Richtung - verläuft, und von der ersten Hauptleiterbahn 10.1 orthogonal (in y-Richtung) abgehende, parallele erste Nebenleiterbahnen 10.2. Entsprechend ist das in der unteren leitfähigen Schicht 4 ausgebildete zweite Leiterbahnsystem 11 mit einer zweiten Hauptleiterbahn 11.1 und von dieser orthogonal bzw. senkrecht abgehenden zweiten Nebenleiterbahnen 11.2 ausgebildet, die wiederum eine Kammstruktur definieren, die gegenüber der Kammstruktur des ersten Leiterbahnsystems 1 entsprechend um 90° versetzt ist, so dass die erste Hauptleiterbahn 11.1 hier in y-Richtung verläuft und die zweiten Nebenleiterbahnen 11.2 in x-Richtung. Anschlüsse (Kontaktierungen) 10.3 und 11.3 der Leiterbahnsysteme 10 und 11 sind zweckmäßigerweise an den Hauptleiterbahnen 10.1 und 11.1 vorgesehen und können insbesondere nahe beieinander ausgebildet sein und somit eine Anschlusseinrichtung 13 bilden.

Weiterhin ist in der oberen leitfähigen Schicht 3, vorzugsweise auch teilweise in der unteren leitfähigen Schicht 4, eine Sensoranordnung 8 aus Sensoreinheiten 9 strukturiert, die z. B. zur Ausbildung von Kondensatoren gegebenenfalls die nicht leitfähige Schicht 2 als Dielektrikum einbeziehen kann. Hierbei können auch Durchkontaktierungen zwischen den leitfähigen Schichten 3 und 4 ausgebildet sein. Die Sensoranordnung 8 kann insbesondere wie gezeigt eine Sensormatrix 8 bilden. Die einzelnen Sensoreinheiten 9 der Sensormatrix 8 sind zwischen die beiden Leiterbahnsysteme 10 und 11 geschaltet und somit mit diesen kontaktiert.

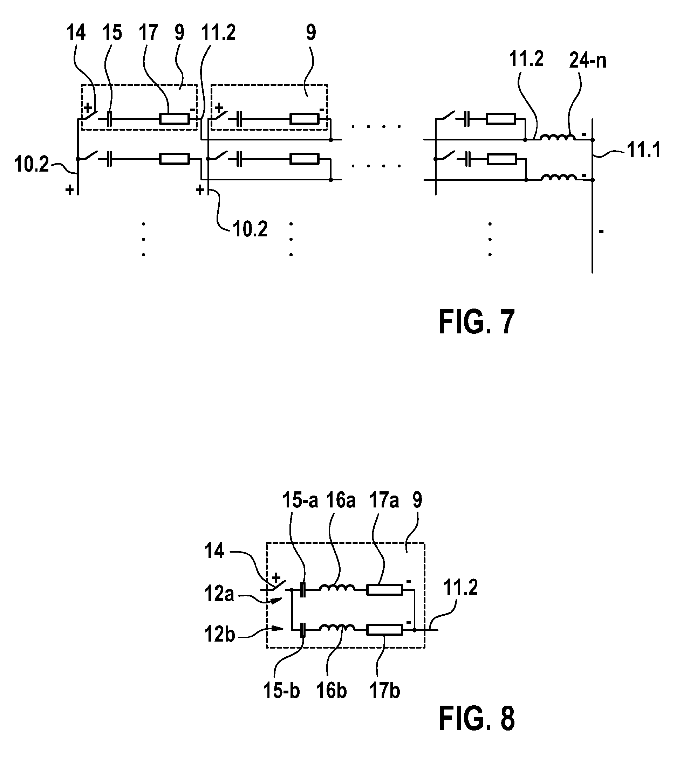

Fig. 2 zeigt eine Sensoreinheit 9 detaillierter. Jede Sensoreinheit 9 weist einen Schwingkreis 12 auf, der gebildet ist als Reihenschaltung aus einem Druckschalter 14, einem Kondensator 15, einer Spule 16 und einer Widerstandseinrichtung 17, wobei die Schaltung auch in anderer Reihenfolge ausgebildet sein kann. Gegebenenfalls können die Sensoreinheiten 9 noch weitere Komponenten bzw. Bauelemente aufweisen, oder wie in Bezug zu Fig. 8 beschrieben auch mehrere Schwingkreise 12. Die Sensoreinheit 9 ist zwischen eine Nebenleiterbahn 10-2 des ersten Leiterbahnsystems und eine Nebenleiterbahn 11-2 des zweiten Leiterbahnsystems geschaltet.

Die Komponenten 14, 15, 16 und 17 des Schwingkreises 12 können erfindungsgemäß vollständig in den leitfähigen Schichten 3 und 4 ausgebildet sein. Der Druckschalter 14 kann gemäß Fig. 4 durch eine obere Schalterfläche 14a (oberer Schalterkontakt), die in der oberen leitfähigen Schicht 3 ausgebildet ist, und eine in der unteren leitfähigen Schicht 4 ausgebildete untere Schalterfläche 14b (unterer Schalterkontakt), sowie einen zwischen den Schalterflächen 14a, 14b ausgebildeten Freiraum 14c ausgebildet sein. Der Freiraum 14c ist somit in der nicht leitfähigen Schicht 2 ausgebildet. Relevant ist, dass bei einer Belastung des Flächenelementes 1 im Bereich der betreffenden Sensoreinheit 9 und somit auf dem Druckschalter 14 durch den einwirkenden Druck p die obere Schalterfläche 14a nach unten gegen die untere Schalterfläche 14b gedrückt wird und diese somit kontaktiert. Die Empfindlichkeit des Druckschalters 14 kann durch die Materialeigenschaften und Dicke der nicht leitenden Schicht 2 und die Größe des Freiraums 14c definiert sein. Erfindungsgemäß wird hier zunächst der Druckschalter 14 nur als Schalter mit Schaltzustand ein oder aus, d.h. Kontakt oder Nichtkontakt betrachtet. Grundsätzlich kann je nach Belastung, d.h. Größe des einwirkenden Drucks p auch gegebenenfalls eine quantitative Differenzierung getroffen werden, wonach der Widerstand des Druckschalters 14 eine Funktion des einwirkenden Drucks p ist.

Der Kondensator 15 kann in lediglich einer der beiden Schichten 3 oder 4, oder auch entsprechend in beiden leitfähigen Schichten 3 und 4 ausgebildet sein. In der Darstellung der Fig. 4 wird der Kondensator 15 direkt rechts angrenzend an den Druckschalter 14 schematisiert angedeutet, ohne Berücksichtigung der größeren Abmessungen und des größeren Abstandes. Der Kondensator 15 weist Kondensatorflächen 15a und 15b in den leitfähigen Schichten 3 und 4 auf, wobei z. B. die nicht leitfähige Schicht 2 als Dielektrikum dienen kann; gegebenenfalls kann das Substrat 2 hier auch besonders ausgebildet sein, mit anderen Materialzusammensetzungen. Somit verläuft hier die Zuleitung 18 von dem Druckschalter 14 zu dem Kondensator 15 in der unteren leitfähigen Schicht 4, wobei in der oberen leitfähigen Schicht 3 ein Freiraum 19 strukturiert ist.

Die Widerstandseinrichtung 16 kann insbesondere als Metallschicht-Widerstand in einer der beiden leitfähigen Schichten 3 oder 4 ausgebildet sein, z. B. wie in Fig. 2 angedeutet durch eine mäanderartige Strukturierung, um den relevanten ohmschen Widerstandswert einzustellen. Die Spule 16 ist vorzugsweise als Flachspule bzw. Spiralspule ausgebildet, wobei die Spiralstruktur z.B. in einer der beiden leitfähigen Schichten 3, 4 ausgebildet ist und entsprechend eine Durchkontaktierung des mittleren Punkts der Spule zu der anderen leitfähigen Schicht erfolgt.

Somit können sämtliche Komponenten 15, 16, 17 des Schwingkreises 12 bzw. die Komponenten 14, 15, 16, 17 der Sensoreinrichtung 9 vollständig in dem Schichtaufbau mit dem leitfähigen Schichten 3 und 4 und der mittleren nicht leitfähigen Schicht 2 ausgebildet werden, bei voller Funktionalität. Insbesondere sind erfindungsgemäß keine zusätzlichen Halbleiterbauelemente hierfür erforderlich.

Die leitfähigen Schichten 3 und 4 können auf die mittlere Schicht 2 z. B. durch Prägen, Drucken oder Jetten strukturiert aufgetragen werden.

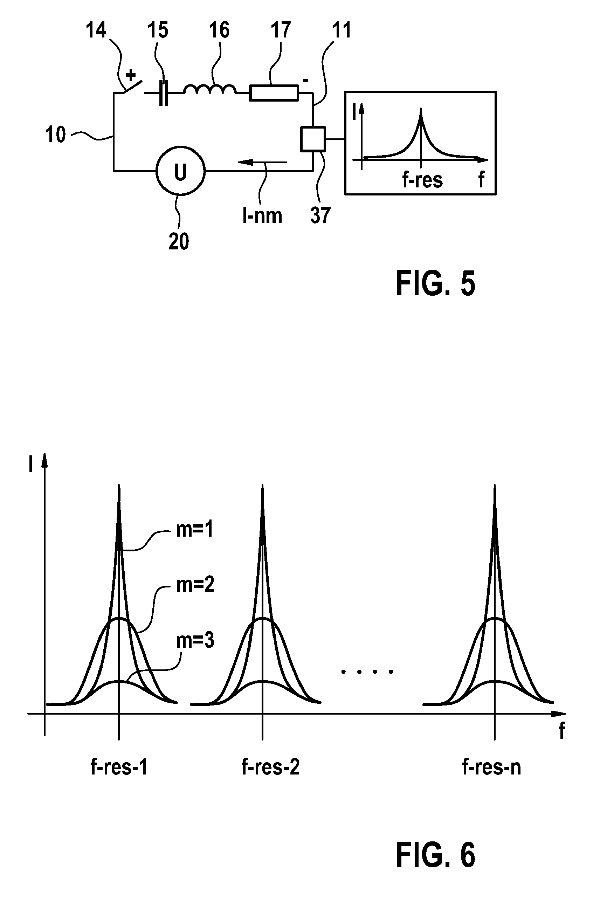

Grundsätzlich können die Komponenten 14, 15, 16 und 17 auch ganz oder teilweise kombiniert ausgebildet werden, z.B. mit einer Flachspule 16, die gleichzeitig als Widerstandseinrichtung 17 dient durch Ausbildung einer dünnen, spiralförmigen Leiterbahn. Der Kondensator kann auch z.B. in lediglich einer der leitfähigen Schichten 3 oder 4 ausgebildet sein, z.B. auch kombiniert mit der spiralförmigen Flachspule 16 durch spiralförmige Ausbildung zweier nebeneinander laufender Leiterbahnen, d.h. ineinander liegenden Spulen. Auch ist die Reihenschaltung der Fig. 3 und 5 entsprechend in anderer Schaltreihenfolge ausbildbar, wie dem Fachmann bekannt ist.

Durch die Leiterbahnsysteme 10 und 11 wird eine Parallelschaltung sämtlicher Sensoreinheiten 9 zwischen das erste Leiterbahnsystem 10 und das zweite Leiterbahnsystem 11 und somit an die Anschlüsse 11.3 und 10.3 erreicht, An die Anschlüsse 10.3 und 11.3 wird gemäß Fig. 5 von einem Rauschgenerator 20 ein Rauschsignal, d.h. eine Rauschspannung U, z. B. als Gleichspannungssignal angelegt. Hierbei kann z.B. das erste Leiterbahnsystem 10 als Plus-Anschluss bzw. positive Spannungszuführung und das zweite Leiterbahnsystem 11 als Minus-Anschluss bzw. negative Spannungszuführung dienen, oder auch umgekehrt. Somit sind sämtliche Sensoreinheiten 9 parallel an den Rauschgenerator 20 angeschlossen. Die unterschiedliche Länge der Leitungsführungen ist vorteilhafterweise gegenüber den ausgebildeten Widerstandseinrichtungen 17 nicht allzu relevant und kann ansonsten bei der Ausbildung der Widerstandseinrichtung 17 berücksichtigt werden.

Aufgrund der Matrixanordnung bilden die Sensoreinheiten 9 Matrixstellen 9-nm der Sensormatrix, mit n = Zeilenzahl und m = Spaltenzahl, mit charakteristischen Schwingkreisen 12-nm. Zur Veranschaulichung der Matrixpositionen werden im folgenden teilweise die indizierungen bei der Sensoreinheit 9 als Matrixstelle 9-nm und seinem Schwingkreis 12-nm verwendet. Gemäß Fig. 5 sendet jede Sendeeinheit 9-nm bei Betätigung ihres Druckschalters 14 aufgrund der Charakteristiken ihres Schwingkreises 12-nm ein Stromsignal I-nm, das in einer Strommesseinrichtung 37 gemessen werden kann. Über die Leiterbahnsysteme 10 und 11 wird somit an die Anschlüsse 10-3 und 11-3 ein Gesamtstromsignal I als Überlagerung sämtlicher Stromsignale I-nm derjeingen Sensoreinheiten 9-nm ausgegeben, deren Druckschalter 14 betätigt sind. Wenn ein entsprechender Druckschalter 14 einer Sensoreinheit 9-nm nicht geschaltet ist, trägt diese Sensoreinheit 9-nm zu einem Gesamtstromsignal I nicht bei. Das Gesamtstromsignal I setzt sich somit als Überlagerung der jeweils bzw. zu dem betreffenden Zeitpunkt t bzw. in einem Zeitraum durchgeschalteten Schwingkreise 12 zusammen. Fig. 5 zeigt rechts ein Stromsignal I-nm in Abhängigkeit der Frequenz f. Der betreffende Schwingkreis 12 bzw. 12-nm weist ein Resonanzverhalten auf, mit einer Resonanzfrequenz f-res. Der Rauschgenerator 20 liefert ein Spannungssignal, das ein "weißes Rauschen" bzw. ein Signal über einen weiteren Frequenzbereich ausgibt, der sämtliche Resonanzfrequenzen sämtlicher Sensoreinheiten 9-nm überdeckt.

Somit können erfindungsgemäß auch für ein großflächiges sensierendes Flächenelement 1 mit einer Vielzahl von Sensoreinheiten 9 bzw. einer Matrixanordnung 9-nm lediglich zwei Leiterbahnsysteme 10 und 11 bzw. zwei Anschlüsse 10.3 und 11.3 vorgesehen sein und dennoch Signale sämtlicher betätigter Sensoreinheiten 9 aufgenommen werden. Erfindungsgemäß sind hierbei die Charakteristiken der Sensoreinheiten 9 bzw. ihrer Schwingkreise 12 verschieden.

Erfindungsgemäß wird erkannt, dass insbesondere zum einen die Resonanzfrequenzen f-res unterschiedlich gewählt und weiterhin als zweiter Parameter die Dämpfung unterschiedlich eingestellt werden kann. Dies ist in dem Strom- Frequenz-Diagramm der Fig. 6 schematisch gezeigt: Bei n verschiedenen Resonanzfrequenzen f-res, d.h. f-res-1, f-res-2....f-res- n ergeben sich entsprechend unterschiedliche Signale. Bei jeder der Resonanzfrequenzen ergeben sich bei unterschiedlichen Dämpfungen unterschiedliche Stromsignale. Hierbei kann die Dämpfung insbesondere durch die unterschiedlichen ohmschen Widerstandswerte der Widerstandseinrichtungen 17 eingestellt werden. Somit können in dem gemeinsamen Stromsignal I aufgrund zweier unterschiedlicher Parameter die einzelnen Stromsignale I-nm differenziert werden. Die Dämpfung kann direkt durch die Amplitude, d.h. die Größe des Strompeaks in Fig. 6, und/oder die Flankenbreite des Signals, charakterisiert werden; alternativ hierzu ist auch eine komplexere Auswertung durch eine Fourieranalyse möglich. Somit definieren Resonanzfrequenz f-res und die Dämpfung die jeweils mit Druck beaufschlagte Sensoreinheit 9.

Bei Anordnung in der zweidimensionalen Matrixform mit Zeilen n und Spalten m der Fig. 1 können die Parameter der Sensoreinheiten 9-nm so ausgebildet werden, das sich die Resonanzfrequenz f-res in jeder Zeile n fest ist und die Dämpfung in jeder Spalte m gleich ist.

Bei einer derartigen Ausbildung mit fester Resonanzfrequenz f-res in jeder Zeile n kann gemäß Fig. 7 auch lediglich eine gemeinsame Spule 24-n als Zeilenspule jeweils an der gemeinsamen Leiterbahn, d.h. bei der Anordnung der Fig. 1 an der betreffenden Nebenleiterbahn 11.2 vorgesehen sein, so dass dann die Sensoreinheiten 9 bzw. 9-nm jeweils ohne eigene Spule bzw. Flachspule 16 ausgebildet werden können. Die gemeinsame Zeilenspule 24-n kann wiederum als Flachspule bzw. Spiralspule ausgebildet sein und ist von Zeile zu Zeile entsprechend unterschiedlich ausgebildet. Somit können die Sensoreinheiten 9 kleiner ausgebildet sein, wodurch die Sensordichte erhöht und/oder Herstellungskosten gesenkt werden können.

Alternativ zu der gezeigten Ausführungsform können die Änderungen in der Resonanzfrequenz f-res auch durch Ausbildung unterschiedlicher Kapazitäten, d.h. Kondensatoren 15 ausgebildet sein, oder es können sowohl Kondensator 15 als auch Spule 16 bzw. Zeilenspule 24-n unterschiedlich ausgebildet sein.

Fig. 8 zeigt eine weitere Ausführungsform, bei der in jeder Sensoreinheit 9 zwei Schwingkreise 12a und 12b ausgebildet und parallel zueinander sowie in Reihe mit dem gemeinsamen Druckschalter 14 geschaltet sind. Eine derartige Ausbildung ist insbesondere vorteilhaft, wenn der jeweilige Druckschalter 14 im Kontaktfall einen zusätzlichen Übergangswiderstand aufweist, und somit die Identifikation der Dämpfung durch den Widerstandswert erschwert wird; dies kann in Fig. 6 insbesondere bei kleinen Unterschieden in den Widerstandswerten von Zeile zu Zeile auftreten. In Fig. 8 weisen die Schwingkreise 12a und 12b somit unterschiedliche Widerstände 17a, 17b, Kondensatoren 15-a, 15-b und Spulen 16a, 16b auf, die auch teilweise gleich dimensioniert sein können, wobei jedoch die Resonanzfrequenzen von 12a und 12b unterschiedlich sind und somit jede Sensoreinheit 9 bei Betätigung des Druckschalters 14 zwei unterschiedliche Resonanzfrequenzen ausgibt.

Erfindungsgemäß kann als einer der zur Unterscheidung der Schwingkreise 12 dienenden Parameter auch eine Phasenverschiebung bzw. ein Phasengang ermittelt werden, z. B. statt der Dämpfung, wobei allerdings die Auswertung des Phasengangs gegebenenfalls komplexer ist.

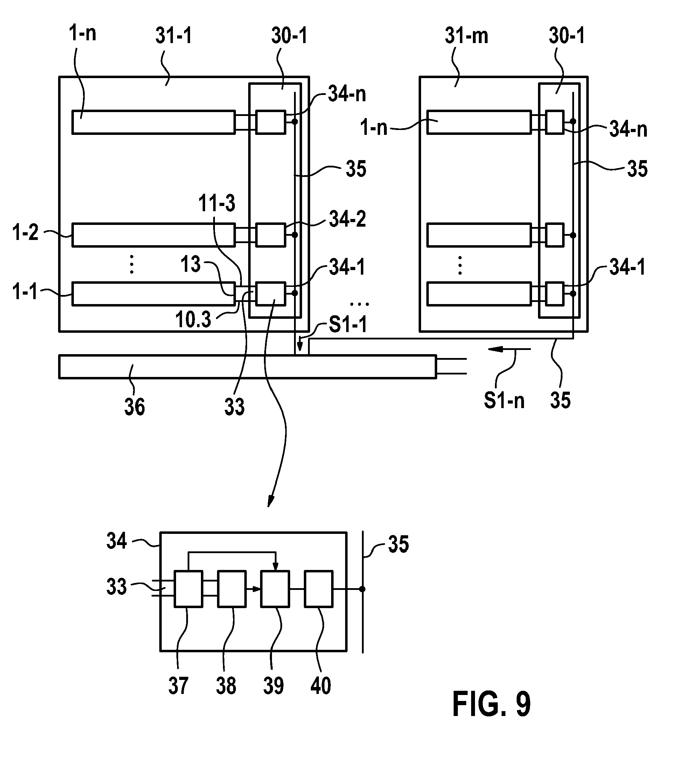

Fig. 9 zeigt die gemeinsame Verlegung mehrerer sensierender Flächenelemente 1, die hier als 1-1, 1-2, d.h. als 1-n mit n=1, 2,... bezeichnet sind. Die Flächenelemente 1-n sind Fußboden-Sensormatten, die durch Roll-to-Roll-Technologie z.B. derartig hergestellt werden, dass ihre Breite fest vordefiniert ist. Die nebeneinander liegenden Flächenelemente 1-n sind mit ihren analogen Anschlusseinrichtungen 13, d.h. ihren beiden analogen Anschlüssen 10.3 und 11.3, an eine Sockelleiste 30 angeschlossen, die bereits auch schematisch in Fig. 1 gezeigt ist, in Fig. 1 aber der Übersichtlichkeit halber nicht angeschlossen ist. Hierbei können gemäß Fig. 9 auch mehrere Sockelleisten 30 vorgesehen sein, z.B. jeweils eine Sockelleiste 30 für einen Raum 31-m, in dem mehrere Flächenelemente 1-n als Fußboden-Sensormatten ausgelegt werden. Somit ist in einem ersten Raum 31-1 eine erste Sockelleiste 30-1, in einem zweiten Raum 31-2 eine zweite Sockelleiste 30-2 vorgesehen, usw., wobei die Sockelleisten 30-m mit m=1, 2, ... an eine Zentraleinheit 36 angeschlossen sind, z.B. durch Busleitungen 35. Jede Sockelleiste 30-m weist jeweils einen Anschluss 33 für die entsprechende Anschlusseinrichtung 13 eines Flächenelementes 1-n, und dezentrale Steuereinrichtungen 34-n, d.h. 34-1, 34-2, ...auf, die jeweils zur Steuerung eines Flächenelementes 1-n vorgesehen sind (in Fig. 1 ist die Steuereinrichtungen 34 ohne Indizierung mit n gezeigt).

Somit nimmt jede Steuereinrichtung 34-n das analoge Gesamt-Stromsignal I eines Flächenelementes 1-n auf und kann eine erste Datenverarbeitung vornehmen. Die Steuereinrichtung 34-n weist somit jeweils den Rauschgenerator 20 der Fig. 5 auf, der die Spannung U als weißes Frequenzrauschen ausgibt, und weiterhin die Strommesseinrichtung 37 zur Detektion des Stroms I, z. B. mittels eines Shunt-Widerstandes oder einer anderen geeigneten Schaltung mit Operationsverstärkern usw. Weiterhin weist die Steuereinrichtung 34-n Filtereinrichtungen zur Filterung des aufgenommenen Stromsignals I, eine Kompensationseinrichtung, eine A/D-Wandlereinrichtung 38, einen Mikrocontroller 39 und einen BUS-Port 40 auf. Die-Kompensationseinrichtung kann z.B. Messsignale von weiteren Sensoren in der Sockelleiste 30, insbesondere einem Temperatursensor und z.B. einem Feuchtesensor aufnehmen, um die Strommesssignale I-nm bzw. das Gesamt-Stromsignal I geeignet zu kompensieren. Somit geben die dezentralen Steuereinrichtungen 34-n digitale Signale S1-n auf die BUS-Leitungen 35, die von den einzelnen Räumen 31-m zu der Zentraleinheit 36 ausgegeben werden. Die Zentraleinheit 36 erfüllt Aufgaben wie Sensoridentifikation und Sensor-Lokalisierung, Aktivitätserkennungen, Ermittlung eines Alarmzustandes und Ausgabe eines Alarmsignals, ggf. auch die Ausgabe von Benachrichtigungssignalen.

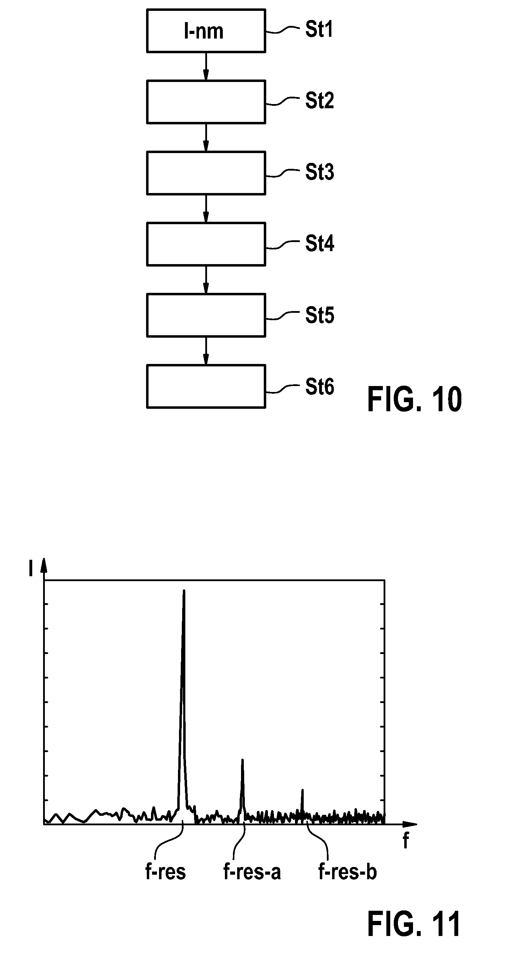

Figur 10 zeigt ein Flussdiagramm eines erfindungsgemäßen Verfahrens. In Schritt St1 werden Stromsignale I-nm der Sensoreinheit 9-nm der einzelnen Flächenelemente 1 von den dezentralen Steuereinrichtungen 34 aufgenommen, in Schritt St2 wird eine Signalvorbereitung, mit Filterung, Temperaturkompensation, ggf. auch Feuchtigkeitskompensation durchgeführt. In Schritt St3 kann als weitergehende Auswertung in den dezentralen Steuereinrichtungen 34 z. B. eine Frequenzanalyse, insbesondere mit einer Fast-Fourier- Transformation und einer Ermittlung charakteristischer Größen, wie Resonanzfrequenz und Amplitude bzw. Dämpfung vorgenommen werden, woraufhin in Schritt St4 von den dezentralen Steuereinrichtungen 34 die jeweiligen Sensoreinheiten 9-nm lokalisiert werden können.

In Schritt St5 können von der Zentraleinheit 36 weitergehende Ermittlungen durchgeführt werden, z. B. Aktivitätserkennungen. Gemäß Figur 13 können z. B. aus den Bewegungsmustern in den einzelnen sensierenden Flächenelementen 1 unterschiedliche Bewegungsabläufe identifiziert werden, z. B. langsame Schritte von einem Menschen, Störsignale, auch Bewegungsmuster anderer Lebewesen, wie z. B. durchlaufende Kleintiere, und insbesondere auch ein Sturzfall als Aktivierung mehrerer Sensoreinheiten in einem zusammenhängenden Flächenmuster. Somit werden die Sensorsignale räumlich (bzw. flächenmäßig) und auch zeitlich ausgewertet, was z. B. durch geeignete Programmierung oder auch durch ein neuronales Netzwerk, ggf. mit Trajektorienerkennung und Vergleich mit gespeicherten Mustern erfolgen kann. Weiterhin können optional zusätzliche Sensoren in den Räumen vorgesehen sein, z. B. Videokameras und IR-Sensoren, wobei IR-Sensoren die Anwesenheit von Personen bzw. Lebewesen und ggf. auch Bewehrungsmuster detektieren können. In Schritt St6 kann von der Zentraleinheit 36 dann eine weitergehende Funktionalität ausgeführt werden, z. B. Ausgabe eines Alarmsignals zur Polizei oder zum Krankenhaus, usw.

Erfindungsgemäß können die einzelnen Sensoreinheiten 9-nm auch weitergehend ausgewertet werden können. Es können charakteristische Größen als "Fingerabdrücke" der Sensoreinheit 9 definiert werden. Sie können zunächst spezifisch anhand der Resonanzfrequenz, Resonanzamplitude und Oberwellen-Amplituden definiert werden. In Figur 11 ist in einem Strom-Frequenz-Diagramm die Abhängigkeit von f gezeigt, mit der Resonanzfrequenz f-res und Oberwellen f-res-a und f-res-b. Weiterhin können die charakteristischen Größen der Sensoreinheiten 9 auch automatisch definiert werden, wobei die Größen durch statistisches Verfahren ausselektiert werden können. Hierbei kann eine große Anzahl von Anfangskerngrößen ausgewertet werden, und auch eine Selektion auf statistischer Basis, z. B. mittels Signifikanztest, Querkorrelation usw. durchgeführt werden.

## Patentansprüche

1. Sensierendes Flächenelement,
das eine Sensoranordnung (8) aus mehreren Sensoreinheiten (9; 9-nm) aufweist, wobei die Sensoreinheiten (9; 9-nm) jeweils mindestens einen taktilen Schalter (14) aufweisen und bei Aktivierung ihres Schalters (14) Signale (I-nm) ausgeben,
**dadurch gekennzeichnet, dass**
den Sensoreinheiten (9; 9-nm) jeweils mindestens ein eigener Schwingkreis (12, 12a, 12b) zugeordnet ist,
die Schwingkreise (12, 12a, 12b) parallel an gemeinsame Leiterbahnsysteme (10, 11) angeschlossen sind und
die Signale (I-nm) der Sensoreinheiten (9; 9-nm) Stromsignale (I-nm) ihrer Schwingkreise (12, 12a, 12b) sind, wobei die Stromsignale (I-nm) zumindest einiger Sensoreinheiten (9; 9-nm) des Flächenelementes (1) unterschiedlich sind.

2. Sensierendes Flächenelement nach Anspruch 1, **dadurch gekennzeichnet, dass**
es ein Schichtsystem (2, 3, 4) aufweist mit mindestens einer elektrisch nicht leitfähigen Schicht (2) und auf der Oberseite (2a) und Unterseite (2b) der nicht leitfähigen Schicht (2) strukturiert ausgebildeten oberen leitfähigen Schicht (3) und unteren leitfähigen Schicht (4),
wobei in der oberen leitfähigen Schicht (3) ein oberes Leiterbahnsystem (10) und in der unteren leitfähigen Schicht (4) ein unteres Leiterbahnsystem (11) strukturiert ist und die Schwingkreise (12, 12a, 12b) der Sensoreinheiten (9) jeweils zwischen die Leiterbahnsysteme (10, 11) geschaltet sind und jeweils bei Anlegen eines Spannungsrauschsignals (U) zwischen die Leiterbahnsysteme (10, 11) und bei Aktivierung ihres Schalters (14) ihre Stromsignale (I-nm) auf die Leiterbahnsysteme (10, 11) ausgeben.

3. Sensierendes Flächenelement nach Anspruch 2, **dadurch gekennzeichnet, dass** die Schwingkreise (12, 12a, 12b) vollständig in der mindestens einen nicht leitfähigen Schicht (2), der oberen leitfähigen Schicht (3) und der unteren leitfähigen Schicht (4) ausgebildet sind.

4. Sensierendes Flächenelement nach Anspruch 3, **dadurch gekennzeichnet, dass** der taktile Schalter ein Druckschalter (14) ist, der eine obere Schalterfläche (14a) und eine untere Schalterfläche (14b) aufweist, zwischen denen mindestens ein Freiraum (14c) im Bereich der mittleren nicht leitenden Schicht (2) ausgebildet ist,
wobei die Schalterflächen (14a, 14b durch Druckbelastung der Sensoreinheit (9) miteinander kontaktierbar sind.

5. Sensierendes Flächenelement nach Anspruch 3 oder 4, **dadurch gekennzeichnet, dass** jeder Schwingkreis (12, 12a, 12b) eine Reihenschaltung aus einer Widerstandseinrichtung (17), einer Flachspule (16, 24-n) und einem Kondensator (15) aufweist, die mit dem taktilen Schalter (14) in Reihe zwischen das obere Leiterbahnsystem (10) und das untere Leiterbahnsystem (11) geschaltet sind.

6. Sensierendes Flächenelement nach Anspruch 5, **dadurch gekennzeichnet, dass**
der Kondensator (15) durch zwei in einer oder beiden leitfähigen Schichten (3, 4) ausgebildete Flächenbereiche (15a, 15b) ausgebildet ist,
die Widerstandseinrichtung (17) als Schichtwiderstand in mindestens einer leitfähigen Schicht (3, 4) ausgebildet ist, und
die Flachspule als Spiralspule (16, 24-n) in mindestens einer leitfähigen Schicht (3, 4) ausgebildet ist.

7. Sensierendes Flächenelement nach einem der Ansprüche 2 bis 6, **dadurch gekennzeichnet, dass** die Leiterbahnsysteme (10, 11) jeweils kammartig und zueinander orthogonal versetzt ausgebildet sind, wobei das obere Leiterbahnsystem eine erste Hauptleiterbahn (10.1) und das untere Leiterbahnsystem (11) eine zweite Hauptleiterbahn (11.1) aufweist, wobei von den Hauptleiterbahnen (10.1, 11.1) jeweils mehrere, parallel zueinander verlaufende Nebenleiterbahnen (10.2, 11.2) verlaufen, zwischen denen die Schwingkreise (12, 12a, 12b) der Sensoreinheiten (9) geschaltet sind.

8. Sensierendes Flächenelement nach einem der Ansprüche 2 bis 7, **dadurch gekennzeichnet, dass** es Durchkontaktierungen zwischen der oberen leitfähigen Schicht (3) und der unteren leitfähigen Schicht (4) aufweist.

9. Sensierendes Flächenelement nach einem der vorhergehenden Ansprüche, **dadurch gekennzeichnet, dass** die Schwingkreise (12, 12a, 12b) sich jeweils in mindestens einer der folgenden Charakteristiken unterscheiden: Resonanzfrequenz, Dämpfung, Frequenzgang.

10. Sensierendes Flächenelement nach Anspruch 9, **dadurch gekennzeichnet, dass** die Sensoranordnung (8) als Sensormatrix mit Zeilen (n) und Spalten (m) ausgebildet ist, wobei die Sensoreinheiten (9; 9-nm) jeweils genau einen Schwingkreis (12) aufweisen und die Schwingkreise (12) zwei spezifische Charakteristiken, insbesondere Resonanzfrequenz und Dämpfung, aufweisen, wobei die Schwingkreise (12) in einer Zeile (n) und/oder in einer Spalte (m) jeweils in einer Charakteristik übereinstimmen und sich in der anderen Charakteristik unterscheiden.

11. Sensierendes Flächenelement nach Anspruch 10, **dadurch gekennzeichnet, dass** die Sensoreinheiten (9-nm) in einer Zeile (n) oder in einer Spalte (m) jeweils jeweils eine Widerstandseinrichtung (17), den Druckschalter (14) und einen Kondensator (15) aufweisen und in Reihe an eine gemeinsame Spule (24-n) geschaltet sind.

12. Sensierendes Flächenelement nach einem der Ansprüche 1 bis 9, **dadurch gekennzeichnet, dass** jede Sensoreinheit (9) mindestens zwei parallel geschaltete Schwingkreise (12a, 12b) mit mindestens einer unterschiedlichen Charakteristik aufweist.

13. Sensierendes Flächenelement nach einem der vorherigen Ansprüche, **dadurch gekennzeichnet, dass** es eine Anschlussleiste (30) aufweist, die die Leiterbahnsysteme (10, 11) kontaktiert, wobei die Anschlussleiste (30) eine dezentrale Steuereinrichtung (34, 34-1, 34-2) aufweist, die ein breitbandiges Spannungsrauschsignal (U) an die beiden Leiterbahnsysteme (10, 11) ausgibt und ein analoges Gesamt-Stromsignal (I) als Überlagerung der einzelnen Stromsignale (I-nm) der Sensoreinheiten (9) über die Leiterbahnsysteme (10, 11) aufnimmt und mindestens einer der
folgenden Signalbearbeitungen unterzieht:
Strommessung, Rauschfilterung, A/D-Umwandlung, Temperaturkompensation, Feuchtigkeitskompensation.

14. Anordnung, die mindestens aufweist:
mehrere sensierende Flächenelemente (1-1, 1-2) nach Anspruch 13, wobei die mehreren Anschlussleisten (30-1, 30-2) der mehreren sensierenden Flächenelemente (1-1, 1-2) an eine Zentraleinheit (36) angeschlossen sind und an die Zentraleinheit (36) digitale Signale (S1-n ) zur Auswertung durch die Zentraleinheit (36) ausgeben.

15. Anordnung nach Anspruch 14, **dadurch gekennzeichnet, dass** die Zentraleinheit (36) aus den aufgenommenen digitalen Signalen (S1) eine Frequenzanalyse und/oder eine Sensorlokalisierung aktivierter Sensoreinheiten (9-nm) und/oder eine Auswertung eines Bewegungsmusters aus der zeitlichen und räumlichen Verteilung der aktivierten Sensoreinheiten (9-nm) vornimmt.
